# EUROPÄISCHE PATENTANMELDUNG

(11) **EP 3 540 290 A1**
(43) Veröffentlichungstag der Anmeldung: **18.09.2019**
(21) Anmeldenummer: 19161039.3
(22) Anmeldetag: 06.03.2019
(51) Int. Cl.: F21S 4/22, F21Y 103/10, F21Y 115/10, F21Y 107/70

(54) **LED-LICHTBAND**

(30) Priorität: 15.03.2018 DE 102018106093
(71) Anmelder: Bilton International GmbH, 5760 Saalfelden (AT)
(72) Erfinder: HOFER, Thomas, 5751 Maishofen (AT); MICHAL, Roland, 1230 Wien (AT); OBERLECHNER, Christian, 5760 Saalfelden (AT)
(74) Vertreter: Epping - Hermann - Fischer

(57) **Zusammenfassung**

Es ist ein LED-Lichtband (1) angegeben, das mindestens eine langgestreckte flexible Leiterplatte (2) aufweist, auf der eine Mehrzahl von LEDs (10) montiert und elektrisch verschaltet ist. An einem Ende der langgestreckten flexiblen Leiterplatte (2) ist eine starre Leiterplatte (3) angeordnet und in das LED-Lichtband (1) integriert, auf der eine weitere Mehrzahl von LEDs (10) montiert und elektrisch verschaltet ist, welche mit den LEDs (10) auf der langgestreckten flexiblen Leiterblatte (2) elektrisch verschaltet sind. Bei einer Ausführungsform ist eine Mehrzahl von langgestreckten flexiblen Leiterplatten (2) und mindestens eine starre Leiterplatte (3) vorgesehen, die zwischen zwei langgestreckten flexiblen Leiterplatten (2) angeordnet ist.

## Beschreibung

Die vorliegende Erfindung betrifft ein Leuchtdioden-Lichtband (im Folgenden "LED-Lichtband"), bei dem eine Mehrzahl von
- LED-Bauelementen - beispielsweise mit einer leadframebasierten Kunststoffumhüllung versehene LED-Chips wie beispielsweise PLCC2 SMD LEDs, PLCC4 SMD LEDs oder PLCC6 SMD LEDs, High-Power SMD LEDs und/oder LED-Chip-Arrays in SMD-Gehäusen (sogenannten CAS-LEDs) - beispielsweise in Oberflächen(SMD)-Montagetechnologie oder
- eine Mehrzahl von LED-Chips in Chip-on-board (COB)-Technologie
auf einer langgestreckten flexiblen, sprich bandförmigen Leiterplatte (auch Flex-PCB genannt) montiert und elektrisch verschaltet ist. Die LED-Bauelemente bzw. LED-Chips sind dabei vorzugsweise linear hintereinander auf dem Flex-PCB montiert. In die LED-Bauelemente bzw. LED-Chips kann Leuchtstoffmaterial zur Lichtkonversion integriert sein. Zusätzlich oder alternativ kann im LED-Lichtband Remote-Phosphor Technologie verwendet sein.

Die lichtemittierenden Halbleiterkörper der LED-Chips können dabei auf anorganischen elektrolumineszierenden Materialien, wie es bei Halbleiter-LEDs der Fall ist, oder organischen elektrolumineszierenden Materialien, wie es beispielsweise bei OLEDs (Organic Light Emitting Diode) der Fall ist, basieren.

LED-Bauelement und LED-Chip werden im Folgenden einheitlich mit "LED" bezeichnet und schließt anorganische LED-Chips sowie organische LED-Chips ein.

Ein flexibles lineares LED-Lichtband zur Verwendung in einem gemäß einer der vorliegend erläuterten Ausführungsformen, Ausgestaltungen und Ausführungsbeispielen ist beispielsweise im Datenblatt BLONE1300024DC12000830000W20 (verfügbar unter https://cdn2.regroshop.at/medias/sys Regro/sheets/sheets/h03/ hd8/9006597767198/Te-BL124120003020.pdf) beschrieben. Hierbei handelt es sich um ein Topview-LED-Lichtband, bei dem die optischen Abstrahlachsen der auf dem Flex-PCB montierten LED-Bauelemente nominal senkrecht zur Montagefläche des Flex-PCBs verlaufen.

Derartige flexible LED-Lichtbänder werden herkömmlich entweder mit an deren Enden angelöteten Kabeln oder an deren Enden angeordneten speziellen Steckverbindern elektrisch an eine Energieversorgung und ggf. elektronische Steuerung angeschlossen.

Solche flexiblen LED-Lichtbänder können in beliebigen durchgängigen Längen hergestellt werden. Gleiche Strukturen können sich in regelmäßigen Abständen wiederholen, beispielsweise alle 5cm. Ein solches LED-Lichtband ist dann in regelmäßigen Abständen trennbar. Beim Verbau sind Rundungen möglich. Abhängig vom gewünschten Lumen-Output kann ein solches LED-Lichtband bis zu einer Länge von ca. 20 Metern ohne zusätzliche Energieeinspeisung zwischen dessen Enden betrieben werden. Sie können schnell und einfach beispielsweise in einem Aluminiumprofil montiert werden und ermöglichen eine sichere Montage beispielsweise mittels eines doppelseitigen Klebebandes. Ebenso ist ein hinreichend gutes Wärmemanagement möglich, denn das dünne Basismaterial eines Flex-PCBs, beispielsweise Polyimid (50 µm + 18 µm Klebstoffschicht), ermöglicht eine gute Wärmeübertragung in das Aluminium-Profil. Mittels des doppelseitigen, wärmeleitenden Klebebands kann eine gute Wärmeankopplung zwischen Flex-PCB und Trägerprofil aus Aluminium realisiert werden, denn das Flex-PCB passt sich sehr gut an die Oberfläche des Trägerprofis an. Das Flex-PCB kann Wärmespannung gut ausgleichen und vermeidet damit thermisch bedingte Abhebungen.

Herkömmliche flexible LED-Bänder ermöglichen eine einfache Logistik, benötigen geringes Lagervolumen und können standardisiert bei der Montage abgelängt werden. Damit eröffnen sie hohe Flexibilität in der Anwendung, hohe Betriebszuverlässigkeit und geringe Systemkosten.

Dem stehen einige Nachteile im Vergleich zu einer starren Leiterplatte (im Folgenden "Starr-PCB"), wie beispielsweise eine sogenannte FR4-Leiterplatte, gegenüber. Der Anschlussbereich eines Flex-PCB weist eine geringere mechanische Festigkeit auf, sodass eine wirkungsvolle Zugentlastung nur schwer möglich ist. Die elektrische Kontaktierung eines Flex-PCB ist schwieriger, da handelsübliche Steckverbinder sowohl oberhalb als auch unterhalb der Flex einen gewissen Raum benötigen, was das Wärmemanagement in diesem Bereich der Kontaktierung beeinträchtigt. Komponenten wie Steckverbinder, Klemmen und Optiken können, wenn überhaupt, nur mit größerem technischen Aufwand montiert werden. Eine elektrische Zwischeneinspeisung beispielsweise in der Mitte des Flex-PCB ist, wenn überhaupt, nur mit großem technischen Aufwand möglich, wegen der schwierigen elektrischen Kontaktierung, da Steck- oder Klemmvorrichtungen, wenn überhaupt, nur mit großem technischen Aufwand montiert werden können. Bei der Montage eines Flex-PCB in einem Montage-Profil sind an den Stellen, an denen die elektrische Kontaktierung erfolgt, Dunkelstellen unvermeidbar. Zwischen dem Ende des Flex-PCBs, an dem Kontaktpads angeordnet sind, und einer erforderlichen Zugentlastung nach dem Ende des Flex-PCBs sind keine LEDs angeordnet. Zudem ist eine Ausrichtung des Flex-PCBs im Zusammenhang mit lagenabhängigen Optiken sehr aufwendig. Eine gleichbleibende Bestückung des FLEX-PCBs muss über die komplette Bandlänge aufrechterhalten werden. Eine Möglichkeit für Multilayer-Konfigurationen besteht nicht; es ist nur eine einfache Beschaltung möglich. Hinzu kommt eine begrenzte Stromtragfähigkeit, insbesondere aufgrund einer geringen maximalen Kupferschichtdicke. Zusammenfassend ist zu sagen, dass ein Flex-PCB nahezu ungeeignet für die Bestückung mit mechanischen Bauteilen ist und, wenn überhaupt, nur mit großem technischen Aufwand Funktionalitäten außerhalb Lichterzeugung und -abgabe übernehmen kann.

Vorliegend liegt insbesondere die Aufgabe zugrunde, ein verbessertes Leuchtdioden-Lichtband der eingangs genannten Art bereitzustellen, welches insbesondere die oben geschilderten Nachteile reduziert.

Diese Aufgabe wird durch ein Leuchtdioden-Lichtband mit den Merkmalen des Patenanspruches 1 gelöst. Vorteilhafte Ausgestaltungen sind in den Unteransprüchen angegeben. Der Offenbarungsgehalt der Patentansprüche wird hiermit durch Rückbezug in die vorliegende Beschreibung aufgenommen.

Bei einer Ausführungsform des LED-Lichtbandes weist dieses mindestens ein flexibles lineares LED-Lichtband der eingangs genannten Art auf, welches eine langgestreckte flexible Leiterplatte, also ein Flex-PCB umfasst, auf der eine Mehrzahl von LEDs montiert und elektrisch verschaltet ist. An mindestens einem Ende des Flex-PCB ist eine - insbesondere langgestreckte - starre Leiterplatte, also ein Starr-PCB angeordnet, auf der eine weitere Mehrzahl von LEDs montiert und elektrisch verschaltet ist.

Bei einer Ausführungsform sind die LEDs auf dem Flex-PCB und auf dem - insbesondere langgestreckten - Starr-PCB in insbesondere identischer geometrischer Anordnung montiert und in insbesondere identisch elektrisch verschaltet. Dadurch kann ein einheitliches Lichtabstrahlungsmuster von dem LED-Lichtband insgesamt erzielt werden, sprich die Lichtabstrahlungsmuster zum einen ausgehend von LEDs auf dem Flex-PCB und zum anderen ausgehend von den LEDs auf dem Starr-PCB sind identisch. Mit "identisch" ist hier durchweg insbesondere gemeint, dass geometrische Anordnung, elektrische Verschaltung und Lichtabstrahlungsmuster nur im Rahmen der üblichen Fertigungstoleranzen und für das menschliche Auge erkennbar identisch, das heißt praktisch identisch und nicht insbesondere messtechnisch exakt identisch oder anderweitig physikalisch exakt identisch sind.

Bei einer Ausführungsform weist das LED-Lichtband eine Mehrzahl von Flex-PCBs auf und ist jeweils zwischen zwei dieser Flex-PCBs ein Starr-PCB angeordnet, deren Mehrzahl von LEDs mit der Mehrzahl von LEDs des benachbarten Flex-PCBs elektrisch verschaltet ist.

Bei einer hierzu weitergehenden Ausführungsform weist das LED-Lichtband an mindestens einem zwischen zwei Flex-PCBs angeordneten Starr-PCB elektrische Anschlusselemente zur elektrischen Energieeinspeisung in das LED-Lichtband auf. Bei einer anderen Ausführungsform weisen alle vorhandenen Starr-PCBs Anschlusselemente zur elektrischen Energieeinspeisung in das LED-Lichtband auf.

Bei einer Ausführungsform des LED-Lichtbandes auf Basis einer Kombination aus mindestens einer flexiblen, bandförmigen Leiterplatte (Flex-PCB) und mindestens einer starren Leiterplatte (Starr-PCB) ist die auf dem Flex-PCB vorhandene Gesamtanordnung der LEDs und Spezifikation der Lichtabgabe in unveränderter Art auf dem Starr-PCB weitergeführt.

Zusätzlich sind bei einer weiteren Ausführungsform auf dem Starr-PCB zusätzliche elektronische und/oder mechanische Komponenten montiert.

Durch eine solche Hybrid-Lösung können die Vorteile des Flex-PCBs voll genutzt werden, während dessen Nachteile durch das Starr-PCB ausgeglichen werden.

Sämtliche Ausführungsformen nutzen die Kompatibilität von Flex-PCB und Starr-PCB bezüglich der Licht-Parameter. Eine solche Hybridlösung mit Flex-PCB und Starr-PCB bringt sowohl technische als auch wirtschaftliche Vorteile mit sich. So sind bedeutende funktionelle Erweiterungen bei linearen Licht-Bändern möglich, die mit Flex-PCBs alleine, wenn überhaupt, nur mit großem Aufwand realisiert werden können. Das Flex-PCB kann bis zu den elektrischen Anschlüssen, beispielsweise Anschluss-Pads, mittels Kleben montiert werden. Damit ist eine gute Wärmeankopplung des Flex-PCB auch im Bereich von elektrischen Anschlüssen möglich. Zudem bleibt die technische Einfachheit der Herstellung von LED-Lichtbändern mit Flex-PCB weitgehend erhalten. Eine doppelseitige Flex-PCB-Lösung, bei dem elektronische und/oder mechanische Komponenten auf der Rückseite des Flex-PCB montiert sind, würde den Meter-Preis von flexiblen LED-Lichtbändern mindestens um den Faktor 3 erhöhen. Es könnten nur wenige Zusatzeigenschaften für das Flex-PCB gewonnen werden. Des Weiteren kann die Anschlusstechnik weitgehend standardisiert werden, wodurch sich Kostenvorteile in der Montage des bestückten LED-Bandes ergeben.

Sämtlichen Ausführungsformen mit den mit LEDs bestückten Starr-PCBs ist gemein, dass darauf zusätzliche mechanische und/oder elektronische Komponenten auf technisch einfache Weise montiert werden können. Stecker und Zugentlastungen können beispielsweise am Ende des flexiblen LED-Lichtbandes ohne Dunkelstelle oder anderweitiger Änderungen der Lichtparameter verwirklicht werden. Im Verlauf des flexiblen LED-Lichtbandes können an dort angeordneten Starr-PCBs Stecker und Zugentlastungen montiert werden, ohne Dunkelstellen oder anderweitige Änderungen der Lichtparameter zu verursachen, wodurch eine Vergrößerung der möglichen Längen von LED-Lichtbändern erzielt werden kann. Spezielle elektronische Funktionen, wie beispielsweise intelligente Temperaturüberwachung, Bewegungssensorik, CO2-Sensorik wie auch Kommunikationseinrichtungen können auf dem/den Starr-PCB/s als LED-Lichtband-Erweiterung realisiert werden.

Das Starr-PCB kann wie das Flex-PCB mit einem wärmeleitenden doppelseitigen Klebeband beispielsweise in ein Aluminiumprofil montiert werden. Als elektrische und/oder mechanische Verbindung zwischen Flex-PCB und Starr-PCB ist beispielsweise eine Lötverbindung vorgesehen. Dazu liegen beispielsweise Lötpins von Starr-PCB und Flex-PCB an deren benachbarten Stirnseiten, an denen die beiden PCBs miteinander verbunden werden sollen, dicht nebeneinander. Für einfache Ausführungen kann als Starr-PCB eine einlagige FR4-Leiterplatte verwendet werden. Für komplexere Schaltungen können starre Multilayer-Leiterplatten zum Einsatz kommen. Für hohe Leistungen bieten sich beispielsweise Metall-Kernleiter-Platten an.

Das LED-Lichtband wird im Folgenden anhand von Ausführungsbeispielen in Verbindung mit den Figuren 1 bis 4 näher erläutert. Es zeigen:
Figur 1, eine schematische Darstellung einer Seitenansicht eines ersten Ausführungsbeispiels;
Figur 2, eine schematische Darstellung einer perspektivischen Ansicht des ersten Ausführungsbeispiels;
Figur 3, eine schematische Darstellung einer Seitenansicht eines zweiten Ausführungsbeispiels;
   und
Figur 4, eine schematische Darstellung einer perspektivischen Ansicht des zweiten Ausführungsbeispiels.

In den unterschiedlichen Ausführungsbeispielen sind gleiche und gleichwirkende Bestandteile figurenübergreifend jeweils mit denselben Bezugszeichen versehen. Die Figuren sind grundsätzlich nicht maßstabsgetreu. Die Größenverhältnisse der verschiedenen Bestandteile untereinander entsprechen nicht der Wirklichkeit. Beispielsweise können vergleichsweise kleine Elemente zur besseren Veranschaulichung übertrieben groß dargestellt sein und umgekehrt.

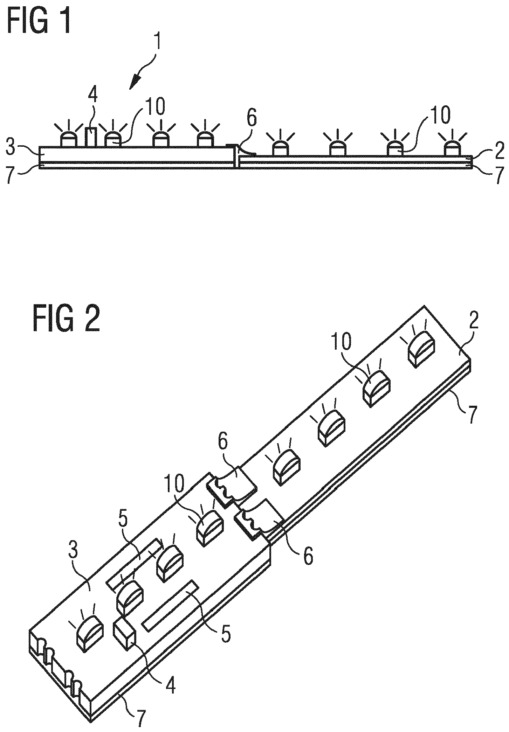

Bei dem in den Figuren 1 und 2 dargestellten Ausführungsbeispiel umfasst das LED-Lichtband 1 eine langgestreckte flexible bandförmige Leiterplatte 2 (Flex-PCB), auf der eine Mehrzahl von LEDs 10 montiert und mittels elektrischen Leiterbahnen auf dem Flex-PCB 2 elektrisch verschaltet ist. Die LEDs 10 sind linear hintereinander in gleichbleibenden Abständen voneinander auf dem Flex-PCB 2 montiert.

Bei den LEDs 10 handelt es sich beispielsweise jeweils um einen mit einer leadframebasierten Kunststoffumhüllung versehenen LED-Chip, beispielsweise um PLCC2 SMD LEDs, PLCC4 SMD LEDs oder PLCC6 SMD LEDs, High-Power SMD LEDs und/oder LED-Chip-Arrays in SMD-Gehäusen (sogenannten CAS-LEDs), die in Oberflächen(SMD)-Montagetechnologie auf dem Flex-PCB 2 montiert und elektrisch verschaltet sind. Ein solches flexibles lineares LED-Lichtband ist beispielsweise im Datenblatt BLONE1300024DC12000830000W20 (verfügbar unter https://cdn2.regroshop.at/medias/sys Regro/sheets/sheets/h03/ hd8/9006597767198/Te-BL124120003020.pdf) beschrieben.

Bei einer alternativen Ausführungsform (nicht gezeigt) handelt es sich bei den LEDs 10 um LED-Chips, die in Chip-on-board (COB)-Technologie auf dem Flex-PCB 2 montiert und elektrisch verschaltet sind.

In die LED-Bauelemente bzw. LED-Chips kann Leuchtstoffmaterial zur Lichtkonversion integriert sein. Zusätzlich oder alternativ kann im LED-Lichtband Remote-Phosphor Technologie verwendet sein.

An einem stirnseitigen Ende des Flex-PCBs 2 ist eine starre Leiterplatte 3 (Starr-PCB) angeordnet und mit dem Flex-PCB 2 beispielsweise über Lötverbindungen 6 oder andere geeignete Verbindungsmittel mechanisch verbunden. Über diese Lötverbindungen 6 können zusätzlich elektrische Leiterbahnen einerseits des Flex-PCBs 2 und andererseits des Starr-PCBs 3 elektrisch miteinander verbunden sein. Es können dazu alternativ oder zusätzlich separate elektrische Verbindungsmittel (zum Beispiel Drahtverbindungen) zwischen Flex-PCB 2 und Starr-PCB 3 vorgesehen sein, mit denen die Leiterbahnen einerseits des Flex-PCBs 2 und andererseits des Starr-PCBs 3 elektrisch verbunden werden.

Auf dem Starr-PCB 3 ist eine weitere Mehrzahl von LEDs 10 montiert und elektrisch verschaltet. Die LEDs 10 des Starr-PCBs 3 sind mit den LEDs 10 des Flex-PCBs 2 elektrisch verschaltet.

Die LEDs 10 auf dem Starr-PCB 3 sind nominal identisch zu den LEDs 10 auf dem Flex-PCB und sind dort nach dem gleichen geometrischen Muster wie auf dem Flex-PCB 2 linear hintereinander in gleichbleibenden Abständen voneinander angeordnet und elektrisch verschaltet. Die beiden benachbarten LEDs 10 einerseits auf dem Flex-PCB 2 und andererseits auf dem Starr-PCB 3 weisen den gleichen Abstand zueinander auf wie die übrigen LEDs 10 auf dem Flex-PCB 2 und dem Starr-PCB 3 untereinander. Das Teil-LED-Lichtband des Flex-PCBs 2 und das Teil-LED-Lichtband des Starr-PCBs 3 sind folglich hinsichtlich ihrer Lichtabstrahlcharakteristik nicht voneinander verschieden, sodass für den Betrachter ein einheitliches Leuchtbild des gesamten LED-Lichtbandes 1 erscheint. Das Starr-PCB 3 ist auf diese Weise sozusagen in das LED-Lichtband 1 integriert.

Die LEDs 10 auf dem Flex-PCB 2 und auf dem Starr-PCB 3 sind durchweg in identischer geometrischer Anordnung montiert und durchweg identisch untereinander elektrisch verschaltet, derart, dass die Lichtabstrahlung ausgehend vom Flex-PCB 2 und die Lichtabstrahlung ausgehend vom Starr-PCB 3 so weitgehend identisch sind, dass für den Betrachter von außen hinsichtlich Lichtabstrahlung kein Unterschied zwischen Flex-PCB 2 und Starr-PCB 3 erkennbar ist.

Bei einer Ausführungsform dieses Ausführungsbeispiels sind auf dem Starr-PCB 3 zusätzlich zu den LEDs 10 elektronische und/oder mechanische Komponenten 4 (gestrichelt eingezeichnet) montiert. Funktionalitäten von solchen zusätzlichen elektronischen und/oder mechanischen Komponenten 4 auf dem Starr-PCB 3 sind weiter oben im allgemeinen Teil der Beschreibung bereits beispielhaft angegeben.

An den von den LEDs 10 abgewandten Flächen des Flex-PCBs 2 und des Starr-PCBs 3 ist jeweils ein Wärmeleitklebeband 7 oder ein über beide PCBs durchgängiges Wärmeleitklebeband 7 vorgesehen, mittels dem das LED-Lichtband 1 beispielsweise in einem Aluminiumprofil eines Gehäuses für das LED-Lichtband 1 befestigt werden kann.

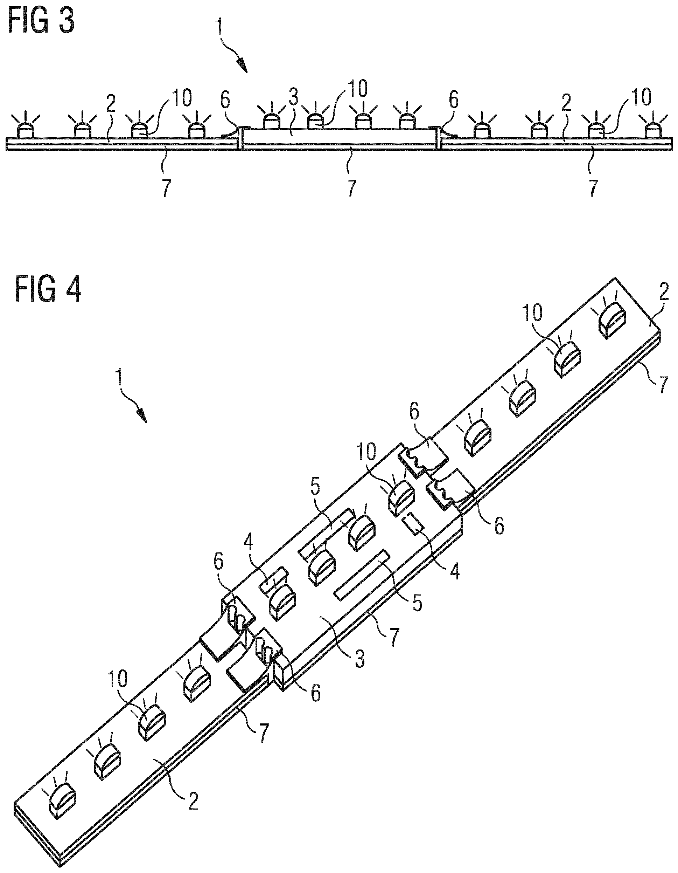

Das in den Figuren 3 und 4 dargestellte zweite Ausführungsbeispiel unterscheidet sich von dem oben erläuterten ersten Ausführungsbeispiel im Wesentlichen dadurch, dass zwei Flex-PCBs 2 vorgesehen sind, zwischen denen ein Starr-PCB 3 angeordnet ist. Die LEDs 10 auf den Flex-PCBs 2 und dem Starr-PCB 3 sind beispielsweise analog zum ersten Ausführungsbeispiel ausgebildet, montiert und elektrisch verschaltet. Die Flex-PCBs 2 und das Starr-PCB 3 sind beispielsweise analog zu den entsprechenden PCBs des ersten Ausführungsbeispiels ausgebildet, miteinander verbunden und elektrisch verschaltet.

Bei einer Ausführungsform des zweiten Ausführungsbeispiels sind an dem Starr-PCB 3 elektrische Anschlusselemente 5 zur Stromeinspeisung in das LED-Lichtband 1 vorgesehen.

Bei einem weiteren Ausführungsbeispiel (nicht gezeigt) weist das LED-Lichtband 1 drei oder mehr Flex-PCBs 2 auf und ist jeweils zwischen zwei Flex-PCBs 2 entsprechend dem oben beschriebenen Ausführungsbeispiel gemäß den Figuren 3 und 4 ein Starr-PCB 3 montiert, deren LEDs 10 analog zu den oben beschriebenen Ausführungsbeispielen montiert und elektrisch verschaltet sind. An jedem Starr-PCB 3 können elektrische Anschlusselemente 5 zur elektrischen Energieeinspeisung vorgesehen sein.

Bei einem weiteren Ausführungsbeispiel (nicht gezeigt) ist eine Mehrzahl von Flex-PCBs 2 und mindestens ein Starr-PCB 3 vorgesehen, das entsprechend dem oben beschriebenen Ausführungsbeispiel gemäß den Figuren 3 und 4 zwischen zwei der Flex-PCBs 2 montiert ist. Die LEDs 10 des Starr-PCBs 3 ist mit den LEDs 10 der beidseitig benachbarten Flex-PCBs 2 elektrisch verschaltet. Am Starr-PCB 3 sind beispielsweise elektrische Anschlusselemente zur elektrischen Energieeinspeisung in das LED-Lichtband 1 vorgesehen.

Bei einem weiteren Ausführungsbeispiel (nicht gezeigt) weist das LED-Lichtband 1 eine Mehrzahl von Flex-PCBs 2 mit mindestens zwei Gruppen von Flex-PCBs 2 auf, zwischen denen entsprechend dem oben beschriebenen Ausführungsbeispiel gemäß den Figuren 3 und 4 ein Starr-PCB 3 montiert ist. Die LEDs 10 des Starr-PCB 3 ist mit den LEDs 10 der beidseitig benachbarten Gruppen von Flex-PCBs elektrisch verschaltet. Mindestens eine der Gruppen von Flex-PCBs 2 weist mindestens zwei Flex-PCBs 2 auf. Am Starr-PCB 3 sind beispielsweise elektrische Anschlusselemente zur elektrischen Energieeinspeisung in das LED-Lichtband 1 vorgesehen.

Die Erläuterung der Erfindung anhand der Ausführungsbeispiele ist nicht als Einschränkung der Erfindung auf diese zu verstehen. Vielmehr können die oben allgemein beschriebenen Elemente und die in den Ausführungsbeispielen beschriebenen Elemente je nach Anforderungsprofil für ein LED-Leuchtband unterschiedlich miteinander kombiniert werden und jedes einzelne Element trägt für sich alleine an den der Erfindung zugrundeliegenden eingangs geschilderten Gedanken bei.
Je nach Anforderungsprofil können die Starr-PCBs unterschiedliche Funktionen und Aufgaben übernehmen.

### Bezugszeichenliste

- 1: LED-Lichtband
- 2: langgestreckte flexible Leiterplatte (Flex-PCB)
- 3: starre Leiterplatte (Starr-PCB)
- 4: elektronische und/oder mechanische Komponente
- 5: elektrisches Anschlusselement
- 6: Lötverbindungen
- 7: Wärmeleitklebeband
- 10: LED

## Patentansprüche

1. LED-Lichtband (1), das mindestens eine langgestreckte flexible Leiterplatte (2) aufweist, auf der eine Mehrzahl von LEDs (10) montiert und elektrisch verschaltet ist,
**dadurch gekennzeichnet, dass**
mindestens an einem Ende der langgestreckten flexible Leiterplatte (2) eine starre Leiterplatte (3) angeordnet und in das LED-Lichtband (1) integriert ist, auf der eine weitere Mehrzahl von LEDs (10) montiert und elektrisch verschaltet ist, welche mit den LEDs (10) auf der langgestreckten flexiblen Leiterblatte (2) elektrisch verschaltet sind.

2. LED-Lichtband (1) gemäß Anspruch 1,
**dadurch gekennzeichnet, dass**
alle LEDs (10) auf der langgestreckten flexiblen Leiterplatte (2) und auf der starren Leiterplatte (3) in identischer geometrischer Anordnung montiert und identisch elektrisch verschaltet sind, derart, dass die Lichtabstrahlungsmuster ausgehend von der langgestreckten flexiblen Leiterplatte (2) und ausgehend von der starren Leiterplatte (3) identisch sind.

3. LED-Lichtband (1) gemäß Anspruch 1 oder 2,
**dadurch gekennzeichnet, dass**
an der starren Leiterplatte (3) zusätzliche elektronische und/oder mechanische Komponenten (4) vorgesehen sind.

4. LED-Lichtband (1) nach einem der Ansprüche 1 bis 3,
**dadurch gekennzeichnet, dass**
es eine Mehrzahl von langgestreckten flexiblen Leiterplatten (2) aufweist und jeweils zwischen zwei langgestreckten flexiblen Leiterplatten (2) eine starre Leiterplatte (3) angeordnet ist, deren LEDs (10) mit den LEDs der benachbarten langgestreckten flexiblen Leiterplatten (2) elektrisch verschaltet sind.

5. LED-Lichtband (1) gemäß Anspruch 4,
**dadurch gekennzeichnet, dass**
an mindestens einer der zwischen zwei langgestreckten flexiblen Leiterplatten (2) angeordneten starren Leiterplatte (3) elektrische Anschlusselemente (5) zur elektrischen Energieeinspeisung in das LED-Lichtband (1) vorgesehen sind.

6. LED-Lichtband (1) nach einem der Ansprüche 1 bis 3,
**dadurch gekennzeichnet, dass**
es eine Mehrzahl von langgestreckten flexiblen Leiterplatten (2) mit mindestens zwei Gruppen von langstreckten flexiblen Leiterplatten (2) aufweist, zwischen denen eine starre Leiterplatte (3) angeordnet ist, deren LEDs (10) mit den LEDs (10) der beidseitig benachbarten Gruppen von langgestreckten flexiblen Leiterplatten (2) elektrisch verschaltet sind, wobei mindestens eine der Gruppen von langgestreckten flexiblen Leiterplatten (2) mindestens zwei flexible langgestreckte Leiterplatten (2) aufweist.

7. LED-Lichtband (1) gemäß Anspruch 6,
**dadurch gekennzeichnet, dass**
an der starren Leiterplatte (3) elektrische Anschlusselemente (5) zur elektrischen Energieeinspeisung in das LED-Lichtband (1) vorgesehen sind.
